# EUROPÄISCHE PATENTSCHRIFT

(11) **EP 3 443 827 B1**
(45) Veröffentlichungstag und Bekanntmachung des Hinweises auf die Patenterteilung: **11.03.2020**
(21) Anmeldenummer: 17717614.6
(22) Anmeldetag: 05.04.2017
(51) Int. Cl.: H05K 7/20, H01L 23/467

(54) **BAUTEILKÜHLVORRICHTUNG**
COMPONENT COOLING DEVICE
DISPOSITIF DE REFROIDISSEMENT DE COMPOSANT

(30) Priorität: 13.04.2016 AT 503172016
(43) Veröffentlichungstag der Anmeldung: 20.02.2019
(73) Patentinhaber: ZKW Group GmbH, 3250 Wieselburg (AT)
(72) Erfinder: EDLINGER, Erik, 1090 Wien (AT); KIESLINGER, Dietmar, 2604 Theresienfeld (AT); WEBER, Emanuel, 2500 Baden (AT)
(74) Vertreter: Patentanwaltskanzlei Matschnig & Forsthuber OG
(86) Internationale Anmeldenummer: PCT/AT2017/060085
(87) Internationale Veröffentlichungsnummer: WO 2017/177249

(56) Entgegenhaltungen:
- EP-A1- 1 777 919
- DE-U1-202014 101 348

## Beschreibung

Die Erfindung betrifft eine Bauteilkühlvorrichtung, umfassend eine Leiterplatte, wobei die Leiterplatte eine Oberseite und eine der Oberseite abgewandte Unterseite, sowie zumindest ein elektronisches Bauteil und zumindest eine hohle Leiterplattendurchführung für ein gasförmiges Kühlmedium zum Kühlen des Bauteils aufweist. Die Bauteilkühlvorrichtung ist insbesondere für die Verwendung in Fahrzeugen und Fahrzeugscheinwerfern vorgesehen.

In der Mikro- und Leistungselektronik werden häufig hohe Verlustleistungen durch elektrische und elektronische Bauteile erzeugt, deren Abwärme über geeignete Bauteilkühlvorrichtungen abgeführt werden muss. Häufig wird ein Kühlkörper direkt auf einem Bauteil angeordnet. Alternativ kann ein Bauteil auf einer Leiterplatte derart angeordnet sein, dass die Leiterplatte selbst die Wärme abführt beziehungsweise an einen Ort transportiert, an dem die Wärme wiederum von einem Kühlkörper aufgenommen wird. Dazu werden häufig "thermische" Durchkontaktierungen eingesetzt, welche meist nur für mehrlagigen Leiterplatten ökonomisch sinnvoll und folglich teuer in der Herstellung sind und daher in kostengünstigen Lösungen wenig Einsatz finden. Die Kühlmethoden nach dem Stand der Technik sind in der Regel teuer, da die benötigten Kühlkörper eine entsprechend große Bauform aufweisen und meist nach dem thermostatischen Prinzip berechnet werden. Die benötigte Baugröße bringt nicht nur entsprechende Stückkosten mit sich, sondern erfordert eine geeignete, meist aufwendige und teure Montage, und die resultierende Gesamtmasse eines derart gekühlten Schaltkreises kann nachteilig für spezielle Anwendungen sein, insbesondere bei mobilen Anwendungen wie beispielsweise in einem Kraftfahrzeug. Vibrationen, verfügbarer Bauraum, Abfuhr von Wärme aus geschlossenen Baugruppen wie einem Fahrzeugscheinwerfer sind weitere begrenzende Aspekte bei der Dimensionierung einer Bauteilkühlvorrichtung, insbesondere für Bauteile von Schaltkreisen für Kraftfahrzeuge, besonders für Fahrzeugscheinwerfer.

Eine Schaltungsanordnung auf einer Leiterplatte für eine erfindungsgemäße Verwendung umfasst zumindest ein elektrisches oder elektronisches Bauteil. Es kann aber auch eine Mehrzahl von derartigen Bauteilen auf einer Leiterplatte angeordnet sein, jedoch sind häufig nur ein Teil der verwendeten Bauteile Leistungsbauteile, die im Betrieb eine hohe elektrische Verlustleistung erzeugen und gekühlt werden müssen. Dafür geeignete Kühlkonzepte betreffen entweder einzelne Bauteile oder auch mehrere Bauteile gemeinsam.

Die EP 1777 919 A1 beschreibt ein Kühlsystem für ein tragbares elektronisches Gerät, das ein wärmeleitendes Element mit zumindest drei in verschiedene Richtungen verlaufenden Ästen aufweist, die mit je einer nach außen führenden luftdurchlässigen Passage verbunden sind.

Es ist Aufgabe der vorliegenden Erfindung eine Bauteilkühlvorrichtung bereitzustellen, die die genannten Nachteile überwindet.

Die Aufgabe wird durch eine Bauteilkühlvorrichtung der eingangs genannten Art gelöst, bei der an der Unterseite der Leiterplatte eine Führung angeordnet ist, welche einen Strömungskanal bildet, der zumindest einen Einlass und zumindest einen von der zumindest einen Leiterplattendurchführung gebildeten Auslass für zumindest einen Konvektionsfluss des Kühlmediums, in der Regel die Umgebungsluft, aufweist. Der zumindest eine Konvektionsfluss kann dabei durch den Strömungskanal und die zumindest eine Leiterplattendurchführung von der Unterseite zur Oberseite strömen. Zudem ist vorteilhafterweise der Strömungskanal durch die Führung und einen Bereich der Unterseite der Leiterplatte begrenzt. Durch diese Anordnung kann mit äußerst geringem Aufwand ein Strömungskanal gebildet werden, da die Leiterplatte selbst auch als eine Begrenzung des Strömungskanals dient und die Führung daher besonders einfach ausgeführt sein kann.

Zusätzlich ist es günstig, wenn die zumindest eine Leiterplattendurchführung ebenfalls in diesem Bereich gelegen ist, was besonders einfach zu realisieren ist.

Zusätzlich ist es günstig, wenn der Bereich des Strömungskanals auf der Unterseite der Leiterplatte zumindest eine Kühlfläche umfasst, wobei die zumindest eine Kühlfläche im Wesentlichen durch eine Kontur beziehungsweise flächige Ausdehnung des zumindest einen Bauteils auf der Leiterplatte begrenzt ist und auf der Unterseite der Leiterplatte gelegen ist. Mit anderen Worten stimmt die Kühlfläche mit der Fläche, die durch das auf der Oberseite montierte Bauteil auf der Leiterplatte bedeckt ist, aber auf der Unterseite der Leiterplatte gelegen ist, überwiegend überein. Die zumindest eine Kühlfläche kann durch das Bauteil erheblich erwärmt werden, weshalb durch einen Konvektionsfluss über die Kühlfläche eine besonders gute Kühlwirkung für das zumindest eine Bauteil erreicht werden kann. Die Kühlfläche kann aber durchaus auch größer sein, insbesondere dann, wenn Wärmespreizflächen oder Wärmeabstrahlflächen auf einer Leiterplatte angeordnet sind.

Es kann ebenfalls vorteilhaft sein, wenn der zumindest eine Einlass des Strömungskanals vorzugsweise eine rechteckige Form aufweist und der Querschnitt des zumindest einen Einlasses größer ist als der Querschnitt des zumindest einen Auslasses; auch kann es vorteilhaft sein, wenn der Strömungskanal eine Höhe quer zur Leiterplatte aufweist, die vom zumindest einen Einlass zum zumindest einen Auslass hin abnimmt.

In einem weiteren Aspekt der Erfindung kann durch die Anordnung einer düsenartigen Struktur, die den Venturi-Effekt nützt, erreicht werden, dass zumindest ein Konvektionsfluss mit aufsteigender Luft von der Unterseite zur Oberseite einer Leiterplatte durch eine Leiterplattendurchführung strömt und dabei Abwärme mitführt. Die düsenartige Struktur ist durch den Strömungskanal und die zumindest eine Leiterplattendurchführung gebildet, wobei der Querschnitt des Strömungskanals ausgehend von dem zumindest einen Einlass hin zum zumindest einen Auslass abnimmt.

Die zumindest eine Leiterplattendurchführung ist vorzugsweise auch in dem Bereich des Strömungskanals auf der Unterseite der Leiterplatte gelegen, was die Kühlwirkung der Anordnung weiter begünstigt.

Ein derartiger Strömungskanal kann besonders einfach und kostengünstig angefertigt werden, indem dieser beispielsweise aus einem Blech gestanzt, gefalzt und mit der Leiterplatte verbunden, vorzugsweise verlötet wird. Dabei weist der Strömungskanal vorzugsweise einen rechteckigen Querschnitt quer zum zumindest einen Konvektionsfluss auf. Eine entsprechende Form des Strömungskanals kann eine kostengünstige Herstellung unterstützen, beispielsweise ein rechteckiger Querschnitt des Strömungskanals, wobei es nicht entscheidend ist, dass die Ecken, Kanten und Seitenwände des Strömungskanals präzise einem Rechteck entsprechen.

Die Kostenvorteile der Erfindung sind besonders groß, wenn die Führung aus drei aneinander angrenzenden Seitenwänden und einer angrenzenden Stirnseite gebildet ist und die Führung gemeinsam mit dem Bereich der Unterseite der Leiterplatte und der Leiterplattendurchführung den Strömungskanal bildet.

Es ist vorteilhaft, wenn der Strömungskanal derart ausgebildet ist, dass drei Seitenwände sowie eine Stirnseite beispielsweise durch ein gestanztes und gefalztes Blech geformt sind und eine vierte Seitenwand des Strömungskanals durch die Leiterplatte gebildet ist. Somit entstehen Kostenvorteile für Material und Montage.

Für die Erfindung können Leiterplatten sowohl für eine SMT-Montage ("Surface Mount Technology") als auch für eine THT-Montage ("Through Hole Technology") eingesetzt werden.

Es ist insbesondere für eine Leiterplatte für eine SMT-Montage günstig, wenn zumindest eine Kontaktanschlussfläche auf der Oberseite mit zumindest einer Wärmeabstrahlfläche auf der Unterseite durch zumindest eine hohle, elektrisch leitende Leiterplattendurchführung verbunden ist.

Für eine Leiterplatte für eine THT-Montage ist es günstig, wenn zumindest ein Kontakt zumindest eines Bauteils durch die Leiterplatte durchgesteckt ist und auf diesem Weg eine Kontaktanschlussfläche mit einer Wärmeabstrahlfläche auf der Unterseite verbunden ist.

Zur verbesserten Wärmeableitung durch den zumindest einen Konvektionsfluss ist es vorteilhaft, wenn zumindest eine Wärmespreizfläche oder zumindest eine Wärmeabstrahlfläche die zur Wärmeableitung geeignete Oberfläche vergrößert. Die zumindest eine Wärmespreizfläche oder Wärmeabstrahlfläche ist vorzugsweise aus einem elektrisch und thermisch leitenden Material ausgeführt, insbesondere aus einer Kupferschicht, die auf zumindest einer Seite der Leiterplatte aufgebracht ist und vorzugsweise strukturiert ausgeführt ist.

Die Kostenvorteile der Erfindung sind besonders groß, wenn die Leiterplatte einlagig ist und beidseitig vorzugsweise strukturierte Metallschichten aufweist.

Es ist besonders vorteilhaft, wenn die zumindest eine Wärmespreizfläche beziehungsweise die zumindest eine Wärmeabstrahlfläche, die auf der Oberseite oder Unterseite der Leiterplatte angeordnet ist, miteinander verbunden ist. Diese Verbindung kann bevorzugt durch zumindest eine elektrisch leitende Leiterplattendurchführung erfolgen, die besonders bevorzugt gleichzeitig den zumindest einen Durchlass für den zumindest einen Konvektionsfluss bildet.

Der zumindest eine Konvektionsfluss kann besonders einfach verstärkt werden, indem die zumindest eine Leiterplattendurchführung mit zumindest einer Kaminstruktur verbunden ist. Es ist vorteilhaft, wenn die Verbindung zwischen der zumindest einen Kaminstruktur und der zumindest einen Leiterplattendurchführung luftdicht, insbesondere durch Löten oder Kleben erfolgt.

Es ist daher besonders günstig, wenn zumindest eine Kaminstruktur zum Verstärken des zumindest einen Konvektionsflusses auf der Oberseite angeordnet ist und die zumindest eine hohle Leiterplattendurchführung in die zumindest eine thermische Kaminstruktur mündet.

Eine besonders vorteilhafte Ausführungsform entsteht, wenn die zumindest eine Kaminstruktur eine Kaminhöhe aufweist, welche größer ist als der Durchmesser der zumindest einen Leiterplattendurchführung bevorzugt zumindest fünfmal größer, besonders bevorzugt zumindest zehnmal größer, und der Kamindurchmesser im Wesentlichen dem Durchmesser der zumindest einen Leiterplattendurchführung entspricht.

Die zumindest eine Kaminstruktur kann vorzugsweise aus einem elektrisch leitenden Material bestehen, um gleichzeitig als Kühlmasse zu dienen. Die zumindest eine Kaminstruktur kann beispielsweise ein Rohr oder eine anders geformte hohle Leitung sein. Ein mechanisch stabiles Material ist günstig, um eine feste Verbindung zur Leiterplatte zu erhalten.

Es ist vorteilhaft, wenn der Kamindurchmesser zumindest teilweise entlang der Kaminhöhe nicht konstant oder an einem Ende der Kaminstruktur, an dem eine Lötverbindung zur Befestigung der Kaminstruktur angebracht wird, erweitert verläuft. Diese Ausgestaltung kann dahingehend vorteilhaft angewandt werden, dass ein erhöhter Querschnitt im Befestigungsbereich der Kaminstruktur zu einer vergrößerten Umfangslänge führt, die der Länge beispielsweise einer Lötverbindung zur Befestigung der Kaminstruktur auf einer Leiterplatte entspricht und folglich zu einer mechanisch belastbareren Verbindung führt. Insbesondere bei Verwendung derartiger Kühlvorrichtungen in einem Fahrzeugscheinwerfer sind solche mechanischen Parameter beispielsweise für Befestigung und Alterung maßgebend. Als Kaminstrukturen sind beispielsweise Adernendhülsen besonders geeignet, die metallisch ausgeführt sind und zudem häufig eine Erweiterung an einem Ende aufweisen.

Die wirksame Kaminhöhe kann in einer Weiterbildung der Erfindung durch eine Verbindung der zumindest einen Kaminstruktur mit zumindest einer zweiten Kaminstruktur vergrößert werden, die stromauf und stromab des Strömungskanals gelegen sein kann. Mit anderen Worten können verschiedener Kaminstrukturen aneinandergereiht werden, die aus unterschiedlichen Materialien, die beispielsweise mechanisch fest oder elastisch formbar ausgebildet sein können, vorzugsweise ein Schlauch, insbesondere ein Gummi- oder Kunststoffschlauch und gemeinsam eine Kaminstruktur ausbilden. Die gemeinsame Kaminstruktur ist vorzugsweise mit zumindest einer weiteren Komponente eines Fahrzeugscheinwerfers verbunden und kann zu einer weiteren Verstärkung der zumindest einen Konvektionsströmung führen.

Insbesondere bei Einsatz einer Kaminstruktur ist es besonders vorteilhaft, wenn eine Leiterplatte in Einbaulage im Wesentlichen horizontal orientiert ist, da dadurch eine vertikal orientierte Kaminstruktur besonders effektiv wirkt und die Bauteilkühlvorrichtung daher besonders effektiv kühlen kann. Bevorzugt ist folglich eine Einbaulage der Leiterplatte mit einem Winkel zur Horizontalen im Bereich -45° bis +45°, besonders bevorzugt im Bereich-10° bis +10°, äußerst bevorzugt im Bereich -5° bis +5°. Spezielle Anordnungen des Strömungskanals oder der Kaminstruktur können jedoch auch eine vertikale Orientierung der Leiterplatte vorsehen.

Die Bauteilkühlvorrichtung ist insbesondere dann vorteilhaft, wenn sie innerhalb eines Fahrzeugscheinwerfers angeordnet ist und vorzugsweise dazu eingerichtet ist um eine Lichtquelle beispielsweise für eine Fernlicht-Lichtquelle oder Abblendlicht-Lichtquelle zu kühlen. Dadurch können die Kosten und das Gewicht für einen Fahrzeugscheinwerfer besonders gering gehalten werden, was erst durch das erfindungsgemäße Kühlkonzept ermöglicht wird. Fernlicht-Lichtquellen oder Abblendlicht-Lichtquellen weisen grundsätzlich höhere Lichtleistungen auf, als beispielsweise Lichtquellen für Blinker. Lichtquellen mit einer höheren Lichtleistung erzeugen im Betrieb auch eine höhere Verlustleistung in Form von Wärme, die durch die erfindungsgemäße Bauteilkühlvorrichtung besonders robust, leicht und kostengünstig gekühlt werden kann.

Für einen Fahrzeugscheinwerfer mit einer oder mehreren Lichtquellen, welche Licht zur Erzeugung einer Lichtverteilung, insbesondere einer Fernlicht- oder Abblendlichtlichtverteilung abstrahlen können, ist die erfindungsgemäße Bauteilkühlvorrichtung zur Kühlung der einen oder mehreren Lichtquellen besonders vorteilhaft einsetzbar, da die Bauteilkühlvorrichtung besonders robust, leicht und kosteneffizient in Kraftfahrzeugen einsetzbar ist.

Die Erfindung und deren Vorteile werden im Folgenden anhand von nicht einschränkenden Ausführungsbeispielen näher beschrieben, die in den beiliegenden Zeichnungen veranschaulicht sind. Die Zeichnungen zeigen in:
- Fig. 1: eine perspektivische Ansicht eines elektronischen Bauteils in SMD-Technik,
- Fig. 2: eine perspektivische Ansicht eines Ausführungsbeispiels einer Führung,
- Fig. 3: eine perspektivische Ansicht einer ersten Ausführungsform einer Bauteilkühlvorrichtung nach der Erfindung,
- Fig. 4: eine Seitenansicht der Bauteilkühlvorrichtung im Vertikalschnitt A-A der Fig. 3,
- Fig. 5: eine perspektivische Ansicht im Schnitt A-A der Fig. 3 auf eine Oberseite der ersten Ausführungsform,
- Fig. 6: eine perspektivische Ansicht im Schnitt A-A der Fig. 3 mit einer Sicht längs des Strömungskanals auf eine Unterseite der ersten Ausführungsform,
- Fig. 7: eine perspektivische Ansicht einer zweiten Ausführungsform einer Bauteilkühlvorrichtung nach der Erfindung,
- Fig. 8: eine perspektivische Ansicht im Vertikalschnitt B-B der Fig. 7 auf eine Oberseite der zweiten Ausführungsform,
- Fig. 9: eine perspektivische Ansicht einer dritten Ausführungsform einer Bauteilkühlvorrichtung nach der Erfindung,
- Fig. 10: eine perspektivische Ansicht im Vertikalschnitt C-C der Fig. 9 auf eine Oberseite der dritten Ausführungsform, jedoch ohne Bauteil,
- Fig. 11: eine perspektivische Ansicht im Schnitt C-C der Fig. 9 mit einer Sicht längs des Strömungskanals auf eine Unterseite der dritten Ausführungsform, jedoch ohne Bauteil,
- Fig. 12: eine perspektivische Ansicht einer vierten Ausführungsform einer Bauteilkühlvorrichtung nach der Erfindung,
- Fig. 13: eine Seitenansicht der Bauteilkühlvorrichtung im Vertikalschnitt D-D der Fig. 12.
- Fig. 14: eine perspektivische Ansicht einer fünften Ausführungsform einer Bauteilkühlvorrichtung nach der Erfindung,
- Fig. 15: eine Seitenansicht der Bauteilkühlvorrichtung im Vertikalschnitt E-E der Fig. 14,
- Fig. 16: eine perspektivische Ansicht im Schnitt E-E der Fig. 14 mit einer Sicht längs des Strömungskanals auf eine Oberseite der zweiten Ausführungsform.

Die im Folgenden verwendeten Begriffe "Oberseite" und "Unterseite" einer Leiterplatte beziehen sich auf die beiden Seiten der Leiterplatte, kennzeichnen jedoch keine Einbaulage der Leiterplatte und dienen nur der besseren Verständlichkeit der Beschreibung. Selbstverständlich hängt es von der jeweiligen Einbausituation ab, ob die Oberseite bzw. Unterseite tatsächlich oben bzw. unten liegt. Daher sind die Begriffe "Oberseite" und "Unterseite" einer Leiterplatte nicht einschränkend zu verstehen und bilden im Sinne ihres wörtlichen Begriffs kein Kennzeichen für die Erfindung. Mit anderen Worten kann eine Leiterplatte einer erfindungsgemäße Bauteilkühlvorrichtung auch schräg ober vertikal montiert sein, und die "Oberseite" muss in eingebautem Zustand in beispielsweise einem Fahrzeugscheinwerfer nicht nach oben orientiert sein.

In den folgenden Ausführungsbeispielen ist jeweils ein Bauteil 6, 106, 206, 306, 406, 506 gezeigt, wobei im Allgemeinen auch mehr als ein Bauteil auf einer Leiterplatte angeordnet sein kann. Zur besseren Verständlichkeit wird im Folgenden nur ein einzelnes Bauteil verwendet, wobei es klar ist, dass auch eine Mehrzahl von Bauteilen gemäß der Formulierung in der allgemeinen Beschreibung und der Ansprüchen gemeint sein kann. Das Gleiche gilt für "einen" Konvektionsfluss, "einen" Einlass, "einen" Auslass sowie "eine" Leiterplattendurchführung, die sich jeweils auf zumindest einen Konvektionsfluss, zumindest einen Einlass, zumindest einen Auslass sowie zumindest eine Leiterplattendurchführung bezieht.

Ferner sind in den folgenden Ausführungsbeispielen Merkmale wie beispielsweise Kontaktanschlussflächen gezeigt, die je nach Ausführungsform der verwendeten Bauteile variieren können. In den gezeigten Darstellungen sind SMD-Bauteile ("Surface Mount Device") für eine SMT-Montage ("Surface Mount Technology") erkennbar, wobei andere Bauformen, die andere Montagetechniken wie beispielsweise die THT-Montage ("Through Hole Technology") erfordern, analog dazu eingesetzt werden können, was insbesondere in der Leistungselektronik eine breite Anwendung findet.

Alle folgenden Ausführungsbeispiele zeigen Varianten der Erfindung und sind in der Anzahl, Art und Anordnung von Komponenten nicht durch die in den Ausführungsbeispielen gezeigten und beschriebenen Merkmale beschränkt. Zur besseren Verständlichkeit wird in den Ausführungsbeispielen eine Schaltungsanordnung mit geringer Komplexität auf einer Leiterplatte gewählt, die nur zur Erklärung der prinzipiellen Funktionsweise der Bauteilkühlvorrichtung dient. Dies ist in keinem Fall einschränkend auf komplexere Schaltungsanordnungen zu sehen. Ferner ist die Erfindung mit konventionellen Bauteilkühlvorrichtungen kombinierbar, insbesondere auf einer gemeinsam genützten Leiterplatte.

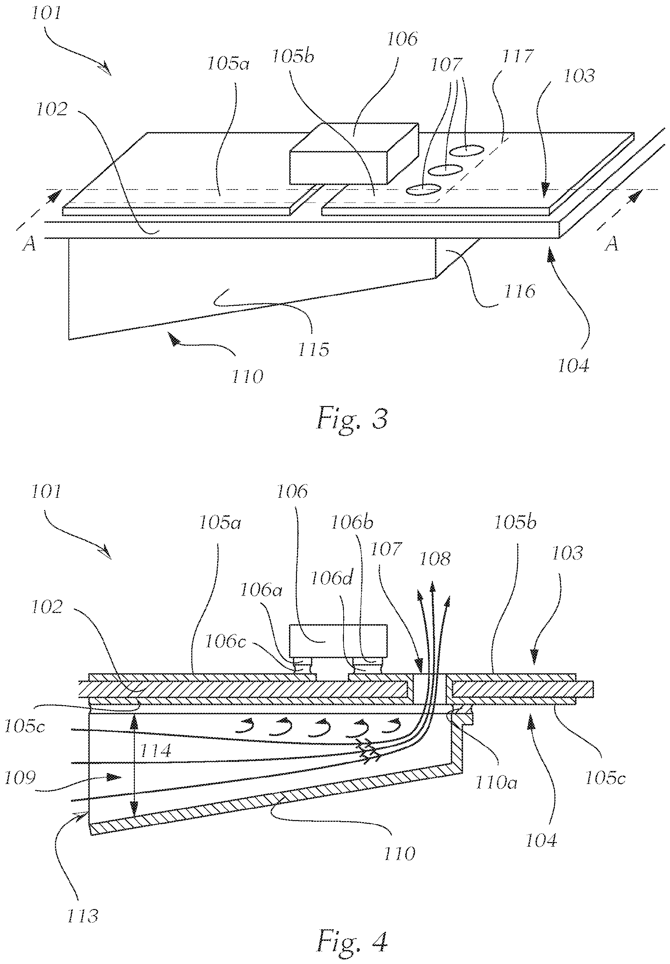

**Fig.** 3 zeigt ein erstes Ausführungsbeispiel einer Bauteilkühlvorrichtung 101 mit einer Leiterplatte 102. Die Leiterplatte 102 hat eine Oberseite 103 und eine der Oberseite abgewandte Unterseite 104 und umfasst zumindest ein elektronisches Bauteil 106, das vorzugsweise auf der Oberseite 103 angeordnet ist. Auf der Oberseite 103 und Unterseite 104 sind metallische Schichten aufgebracht, die derart strukturiert sind, dass sie beispielsweise Leiterbahnen oder Kontaktanschlussflächen 105a, 105b, sowie Wärmeabstrahlflächen 105c umfassen. Ferner weist die Leiterplatte 102 beispielsweise drei vorzugsweise hohlzylindrische Leiterplattendurchführungen 107 auf, die vorzugsweise elektrisch leitend ausgeführt sind, um die metallische Schicht auf der Oberseite 103 mit der metallischen Schicht auf der Unterseite 104 elektrisch und folglich auch thermisch gut miteinander zu verbinden.

Grundsätzlich ist es aber nicht notwendig, die Schicht der Unterseite 104 in die Bauteilkühlvorrichtung mit einzubeziehen. Somit ist es nicht immer notwendig, die Leiterplattendurchführungen 107 elektrisch leitend auszuführen. Es lässt sich aber durch Einbeziehung der Schicht auf der Unterseite 104 eine besonders gute Kühleffizienz erzielen.

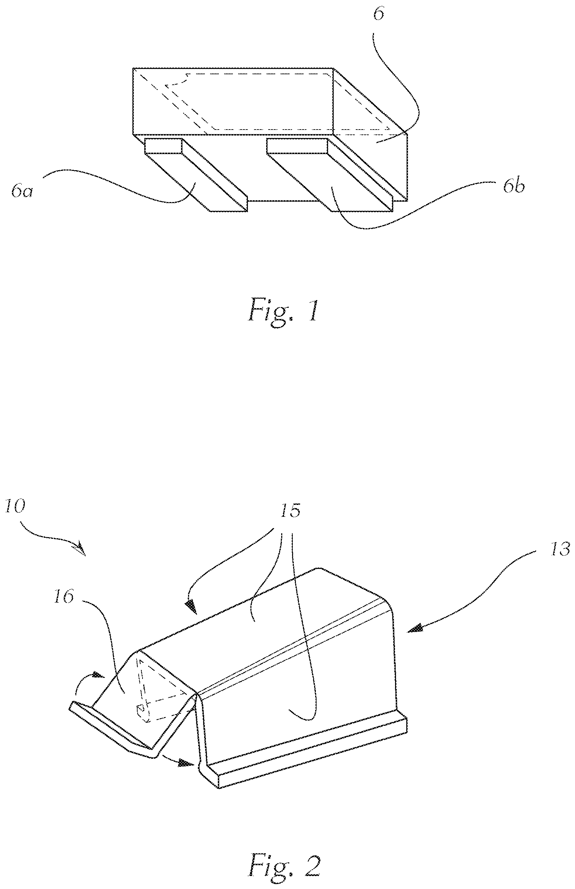

**Fig. 1** zeigt ein Beispiel für ein elektronisches Bauteil 6, das auch für ein Bauteil 106 nach Fig. 3 geeignet ist, in einer perspektivischen Ansicht. Das elektronische Bauteil 6 ist in verschiedenen Ausführungsbeispielen der Bauteilkühlvorrichtung eine Leuchtdiode in SMD-Technik und umfasst ein Gehäuse mit zwei Kontaktanschlüssen 6a, 6b die mit einer Anode und einer Kathode der Leuchtdiode verbunden sind. Eine Leuchtdiode besteht bekanntlich aus einem Halbleiterkristall und erzeugt im Betrieb neben dem abgestrahlten Licht eine Verlustleistung, die in Form von Wärme abgegeben wird, deren Abfuhr mittels der erfindungsgemäßen Bauteilkühlvorrichtung erleichtert werden kann. Alternativ kann das elektronische Bauteil 6 ein ohmscher Widerstand sein.

Der erste Kontaktanschluss 6a des Bauteils 6 für die Anode ist meist kleiner ausgeführt als der zweite Kontaktanschluss 6b der Kathode, da bauteilintern die Kathode an der Grundfläche des Halbleiterkristalls, aus dem die Leuchtdiode besteht, gelegen sein kann und mit dem zweiten Kontaktanschluss 6b des Bauteils 6 flächig verbunden sein kann. Die Anode liegt beispielsweise auf einer Oberseite des Halbleiterkristalls und ist über einen Bonddraht mit dem zweiten Kontaktanschluss 6a des Bauteils 6 verbunden. Der innere Aufbau des Bauteils ist in den Figuren nicht dargestellt.

Wieder Bezug nehmend auf Fig. 3 ist erkennbar, dass die beiden Kontaktanschlüsse 106a, 106b des Bauteils 106, das dem Beispiel des Bauteils 6 aus Fig. 1 entspricht, der Leiterplatte 102 zugewandt sind.

Das elektronische Bauteil 106 ist über die Kontaktanschlüsse 106a, 106b mit Leiterbahnen bzw. Kontaktanschlussflächen 105a, 105b, die sich auf der Oberseite 103 der Leiterplatte 102 befinden, verbunden, vorzugsweise verlötet, beispielsweise im Zuge einer SMD-Montage.

Zur Verbesserung der Wärmeableitung (d.h. Erzielen eines niedrigeren thermischen Widerstandes) sind die Kontaktanschlussflächen 105a, 105b vorzugsweise großflächig auf der Leiterplatte 102 innerhalb der genannten Schichten ausgebildet. Die Kontaktanschlussflächen 105a, 105b sind sowohl elektrisch als auch thermisch gut leitend. Derartige ausgedehnte Kontaktanschlussflächen 105a, 105b werden auch als "Wärmespreizflächen" bezeichnet.

Im vorliegenden Beispiel ist innerhalb des Bauteils 106 der zweite Kontaktanschluss 106b durch die flächige Verbindung zur Kathode für die Wärmeableitung besonders geeignet. Im Vergleich dazu ist der erste Kontaktanschluss weniger gut zur Wärmeableitung geeignet, da die Verbindung zur Anode durch einen Bonddraht ausgeführt ist und der Bonddraht einen deutlich geringeren Querschnitt für die Wärmeableitung aufweist, als der flächige Anschluss der Kathode. Daher ist es besonders vorteilhaft, wenn die hohlzylindrischen Leiterplattendurchführungen 107 in relativ kurzem Abstand zur Sollbestückungsposition des Kontaktanschlusses 106b auf der zweiten Kontaktanschlussfläche 105b angeordnet sind, um die erfindungsgemäße Bauteilkühlvorrichtung 101 besonders effektiv zu gestalten. Man wird somit jenen Anschluss oder jene Anschlüsse eines Bauteils bevorzugt wählen, die innerhalb des Bauteils mit dessen thermischer Masse, also dem Bauteilgehäuse, verbunden sind, um sie mit jener Wärmespreizfläche zu verbinden, von der durch die Bauteilkühlvorrichtung ein verbesserter Wärmeabfluss möglich ist.

Die Unterseite 104 der Leiterplatte 102 umfasst ebenfalls eine metallische Schicht, die sowohl für elektrische Verbindungen, als auch für thermische Wärmespreizflächen strukturiert und verwendet werden kann. Es ist günstig, wenn die Wärmespreizflächen 105a, 105b der Oberseite 103 mit der Wärmeabstrahlfläche 105c der Unterseite 104 verbunden sind, was in diesem Ausführungsbeispiel durch die elektrisch leitenden Leiterplattendurchführungen 107 erfolgt.

In **Fig. 4** ist erkennbar, dass das Bauteil 106 durch einen Konvektionsfluss 108 eines Kühlmediums, beispielsweise Umgebungsluft, von der Unterseite 104 zur Oberseite 103 kühlbar ist. Der Konvektionsfluss 108 kann durch einen Strömungskanal 109 und durch die hohlen Leiterplattendurchführungen 107 strömen.

Der Strömungskanal 109 kann auf der Unterseite 104 zumindest auf einer Kühlfläche der Leiterplatte 102 angeordnet sein, wobei die Kühlfläche in ihrer horizontalen Ausdehnung durch die Kontur des Bauteils 106 begrenzt sein kann und auf der Unterseite 104 der Leiterplatte 102 gelegen ist. Die Kühlfläche kann durchaus auch größer sein, insbesondere, wenn Wärmespreizflächen oder Wärmeabstrahlflächen auf der Leiterplatte 102 angeordnet sind. In der Regel wird durch den Strömungskanal 109 eine deutlich größere Fläche belegt, als nur jene der Kühlfläche. Die tatsächliche Fläche, die durch den Strömungskanal 109 definiert ist, wird nachstehend als Begrenzungsfläche bezeichnet. Der Konvektionsfluss 108 kann folglich mittels des Strömungskanals 109 im Wesentlichen über seine leiterplattenseitige Begrenzungsfläche geleitet werden, womit gemeint ist, dass der überwiegende Teil des Konvektionsflusses durch den Strömungskanal geleitet werden kann, aber durchaus weitere Ein- und Auslässe vorgesehen sein können, um mehrere Konvektionsflüsse zu erzeugen, um beispielsweise Kühlwirkungen an mehreren Orten auf der Leiterplatte 102 zu erzielen.

Der Strömungskanal 109 umfasst einen Einlass 113, dessen Querschnitt beispielsweise eine rechteckige Form aufweist und einen Auslass, der durch die hohlen Leiterplattendurchführungen 107 gebildet ist. Die Leiterplattendurchführungen 107 können folglich im Bereich des Strömungskanals 109 gelegen sein. Der Querschnitt des Einlasses 113 ist vorzugsweise größer als der Querschnitt des Auslasses. Der Strömungskanal 109 kann eine Höhe 114 quer zur Orientierung der Leiterplatte 102 aufweisen, die trichterförmig vom Einlass 113 zum Auslass hin abnimmt.

Der Strömungskanal 109 formt durch den geringer werdenden Querschnitt des Strömungskanals 109 eine Düse, die einen Konvektionsfluss 108 durch die hohlen Leiterplattendurchführungen 107 verstärkt. Mit anderen Worten wird die Strömungsgeschwindigkeit durch den Strömungskanal 109 und die Leiterplattendurchführungen 107 erhöht, wodurch die Wärmeabfuhr beziehungsweise die Bauteilkühlung verbessert wird. Die Höhe 114 des Strömungskanals 109 sorgt für einen vergrößerten Höhenunterschied zwischen dem Einlass 113 und dem Auslass (die Leiterplattendurchführung 107) des Strömungskanals 109 und begünstigt die Konvektion der Luft durch die Anordnung in vertikaler Richtung.

In diesem Beispiel weist der Strömungskanal 109 eine Form eines hohlen Pyramidenstumpfs auf. Drei Seitenwände 115 und eine Stirnseite 116 sind durch eine Führung 110 gebildet. Die vierte Seitenwand des Strömungskanals 109 ist durch eine Teilfläche der Leiterplatte 102, die genannte Begrenzungsfläche auf der Unterseite 104 der Leiterplatte 102 gebildet. Die hohlen Leiterplattendurchführungen 107 sind innerhalb des Innenraums des Strömungskanals 109 gelegen, was durch die Linie 117 in Fig. 3 verdeutlicht ist, die eine auf die Oberseite 103 projizierte Kontur des Strömungskanals 109 zeigt.

In **Fig. 2** ist ein Beispiel einer Führung 10, die für verschiedene erfindungsgemäße Ausführungsbeispiele geeignet ist, insbesondere für einen Strömungskanal 109 nach Fig. 4, gezeigt, der drei Seitenwände 15 und eine Stirnseite 16 umfasst. Der Stirnseite 16 liegt abgewandt des Einlasses 13. In diesem Beispiel kann die Führung 10 aus einem Blech gefertigt sein, das zur Formung eines Strömungskanals geeignet zugeschnitten und bei dem die Seitenwände 15 umgebogen werden können, was durch die Pfeile in Fig. 2 dargestellt ist. Günstig ist es, wenn zusätzlich die begrenzenden Kanten des so geformten Strömungskanals umgebogen sind, um eine einfache Verbindung, beispielsweise durch Löten, mit einer Metallschicht auf einer Leiterplatte herstellen zu können.

Die gezeigte Form der Führung 10 bietet Kostenvorteile, da der Strömungskanal gesamt gesehen zusammen erst mit einer Leiterplatte gebildet ist und folglich der Materialaufwand der Führung 10 um eine Seitenwand reduziert ist.

Wieder Bezug nehmend auf Fig. 4 kann die Führung 110 vorzugsweise mit einer Lötverbindung 110a an einer Leiterplatte 102 befestigt werden. Grundsätzlich kann die Befestigung der Führung 110 an der Leiterplatte 102 beispielsweise auch durch Klebung, vorzugsweise durch einen elektrisch schlecht oder nicht leitenden, aber thermisch gut leitenden Klebstoff oder durch eine Steck- oder Schraubverbindung erfolgen.

Wieder bezugnehmend auf Fig. 4 kann, um die Wärmespreizfläche weiter zu vergrößern, auf der Unterseite 104 der Leiterplatte 102 zusätzlich eine metallische thermische Wärmeabstrahlfläche 105c angeordnet sein, die durch die Leiterplattendurchführung 107 thermisch mit der Kontaktanschlussfläche 105b verbunden ist. Durch diese Ausgestaltung strömt der Konvektionsfluss 108 durch den Strömungskanal 109 an der Wärmeabstrahlfläche 105c vorbei, wobei die Kühlwirkung verbessert wird. Zusätzlich kann durch Verwendung einer metallischen Führung 110 gemeinsam mit einer thermisch leitenden Verbindung 110a zur Wärmeabstrahlfläche 105c die Kühlwirkung weiter verbessert werden, da die Führung 110 als Kühlkörper wirkt und den gesamten thermischen Widerstand weiter verringert.

Die Leiterplatte 102 ist vorzugsweise einlagig und beidseitig mit metallischen Schichten ausgeführt und die Schichten sind vorzugsweise strukturiert. Die Leiterplatte 102 ist vorzugsweise aus einem Leiterplattenmaterial wie FR4 ausgeführt. Grundsätzlich sind auch mehrlagige Leiterplatten verwendbar. Die erfindungsgemäße Kühlvorrichtung ist durch ihre einfache Konstruktion insbesondere für kostengünstige Anwendungen geeignet, die meist einlagige Leiterplatten einsetzen.

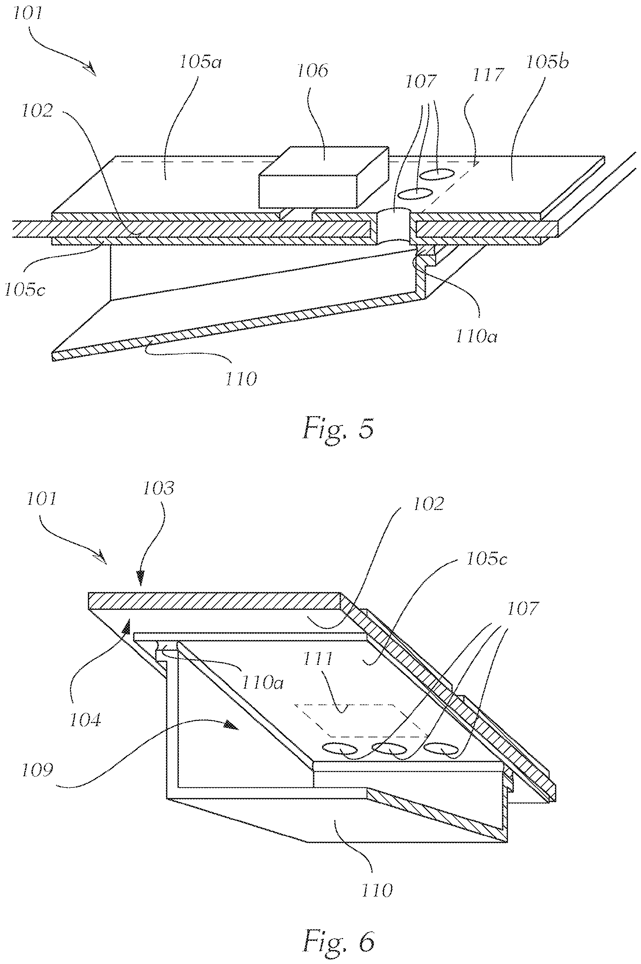

In **Fig. 5** und **Fig. 6** ist erkennbar, wie die Führung 110 gemeinsam mit einer Teilfläche der Unterseite 104 der Leiterplatte 102 den Strömungskanal 109 bildet. Die Leiterplatte 102 kann eine metallisch beschichtete Unterseite 104 umfassen, die mittels einer Lötverbindung 110a mit der Führung 110 verbunden sein kann. Die hohlen Leiterplattendurchführungen 107 können innerhalb des Innenraums des Strömungskanals 109 zur Ausbildung des Auslasses gelegen sein.

Das Bauteil 106 kann dem Beispiel des Bauteils 6 aus Fig. 1 entsprechen und die Führung 110 kann dem Beispiel der Führung 10 aus Fig. 2 entsprechen.

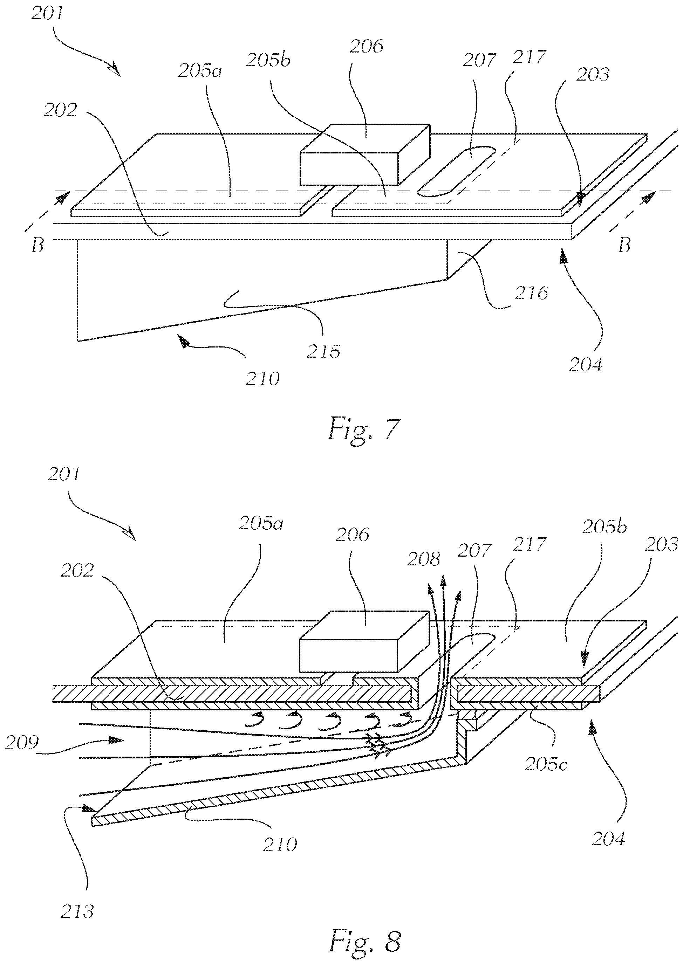

**Fig. 7** und **Fig. 8** zeigen ein zweites Ausführungsbeispiel einer Bauteilkühlvorrichtung 201 mit einer Leiterplatte 202 und einem elektronischen Bauteil 206, das auf einer Oberseite 203 montiert ist. Eine hohle Leiterplattendurchführung 207 weist eine im Wesentlichen stadionförmige oder ellipsenförmige Form ihres Querschnitts auf, um einen größeren Querschnitt in einer horizontalen Ebene für einen Konvektionsfluss 208 bereitzustellen.

Im Übrigen gilt das Gleiche wie im ersten Ausführungsbeispiel.

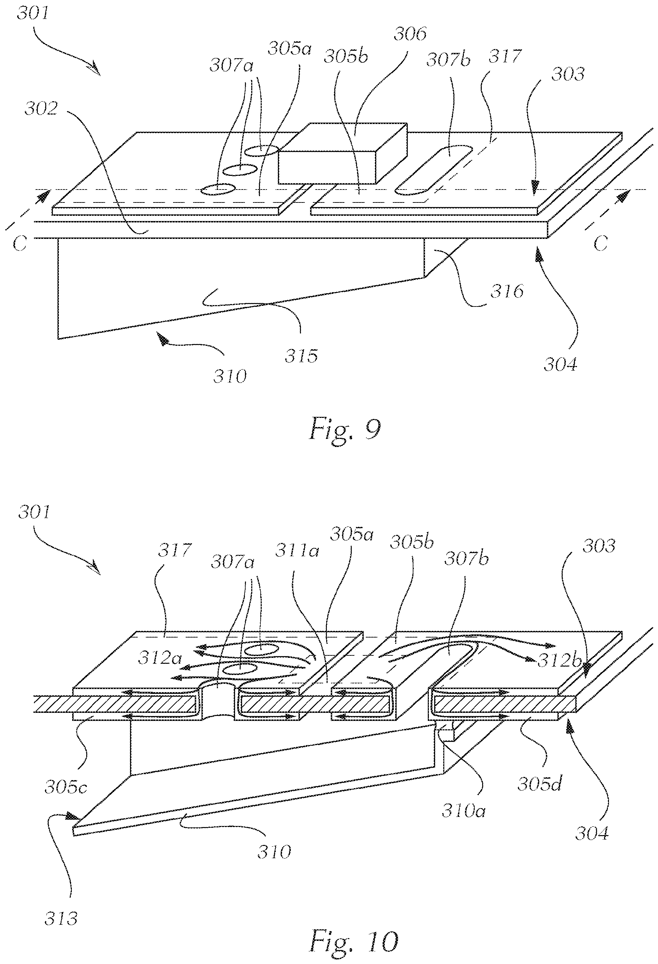

**Fig. 9** bis **Fig. 11** zeigen ein drittes Ausführungsbeispiel einer Bauteilkühlvorrichtung 301 mit einer Leiterplatte 302 zur Montage eines elektronischen Bauteils 306 auf einer Oberseite 303. Außerdem sind hohle Leiterplattendurchführungen 307a und 307b gezeigt, wobei die Leiterplattendurchführungen 307a beispielsweise durch drei hohlzylindrische Öffnungen gebildet sind und die Leiterplattendurchführung 307b durch eine Öffnung mit beispielsweise länglichem, stadionförmigem oder ellipsenförmigem Querschnitt gebildet ist. Die Form der Leiterplattendurchführung ist nicht entscheidend, sondern vielmehr aber der Querschnitt, der die Stärke des Konvektionsflusses 208 mitbestimmt. In Fig. 10 ist dargestellt, wie sich ein thermischer Fluss 312a, 312b innerhalb leitender Wärmespreizflächen ausbreiten kann. Zu Vergleichszwecken wird hier davon ausgegangen, dass beide Wärmequellen, die durch das Bauteil 306 gemäß Fig. 9 gebildet sind, die gleiche Wärmeabgabe aufweisen, und die beiden thermischen Flüsse 312a und 312b in der Intensität gleich hoch sind. Zur besseren Darstellung ist das Bauteil 306 in Fig. 10 nicht eingezeichnet. Es ist erkennbar, dass durch die drei hohlzylindrischen Leiterplattendurchführungen 307a eine bessere Wärmeableitung durch den thermischen Fluss 312a erreicht wird, als vergleichsweise durch den thermischen Fluss 312b, der um die längliche Leiterplattendurchführung 307b "herum" fließen muss.

Andererseits ist die Querschnittsfläche aller drei hohlzylindrischer Leiterplattendurchführungen 307a zusammen geringer als die Querschnittsfläche der länglichen Leiterplattendurchführung 307b. Folglich wird durch die längliche Leiterplattendurchführung 307b ein verstärkter Konvektionsfluss erzielt.

Die Wahl der Form der Leiterplattendurchführungen wird oft herstellungstechnisch getroffen. Andere Formen für die Leiterplattendurchführungen 307a 307b sind daher möglich.

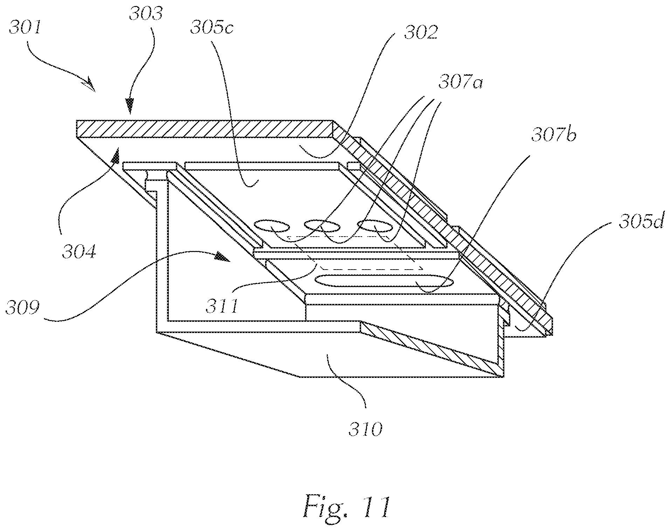

Durch die Leiterplattendurchführungen 307a, 307b werden die Kontaktanschlussflächen 305a, 305b nach Fig. 9 mit der metallbeschichteten Unterseite 304 thermisch und elektrisch verbunden. Damit die Kontaktanschlussflächen 305a, 305b nicht bei Herstellen einer Lötverbindung 310a mit einer metallisch leitenden Führung 310 elektrisch kurzgeschlossen werden, ist darauf zu achten, dass die Unterseite 304 entsprechende Strukturierungen der Wärmeabstrahlflächen 305c, 305d in der Metallschicht aufweist, was in Fig. 11 erkennbar ist.

Im Übrigen gilt das Gleiche wie den vorhergehenden Ausführungsbeispielen.

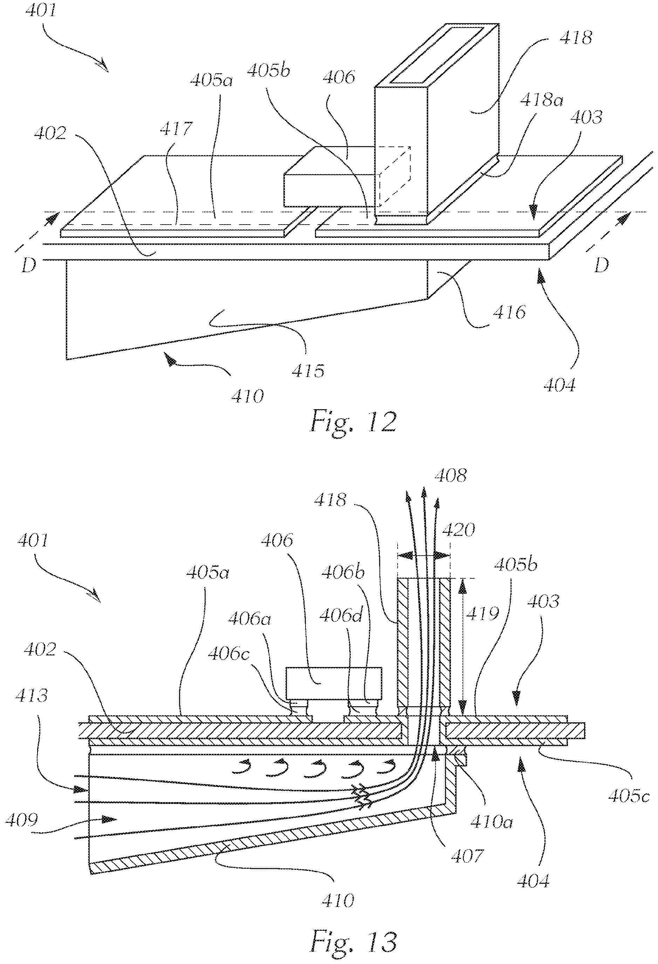

**Fig. 12** und **Fig. 13** zeigen ein weiteres Ausführungsbeispiel einer Bauteilkühlvorrichtung 401 mit einer Leiterplatte 402 und einem elektronischen Bauteil 406, das auf einer Oberseite 403 montiert ist. Zusätzlich ist auf einer Leiterplattendurchführung 407 eine thermische Kaminstruktur 418 erkennbar.

Die thermische Kaminstruktur 418 dient zum Verstärken des vertikalen Konvektionsflusses 408 und ist auf der gegenüberliegende Seite, auf welcher sich der Strömungskanal 409 befindet, derart angeordnet, dass die hohle Leiterplattendurchführung 407 in die thermische Kaminstruktur 418 mündet.

Dabei weist die Kaminstruktur 418 eine vertikale Kaminhöhe 419 auf, wobei die Kaminhöhe 419 größer ist als der Durchmesser der Leiterplattendurchführung 407, bevorzugt zumindest fünfmal größer, besonders bevorzugt zumindest zehnmal größer. Die Wahl der Kaminhöhe erfolgt nach verfügbarem Einbauraum für die Bauteilkühlvorrichtung 401. Der horizontale Kamindurchmesser 420 entspricht im Wesentlichen dem Durchmesser der Leiterplattendurchführung 407. Die Kaminstruktur 418 ist vorzugsweise über eine Lötverbindung 418a mit der Leiterplatte 402 verbunden, um eine gute thermische Verbindung zwischen der Kaminstruktur 418 und der Leiterplatte 402 zu erzielen. Dadurch kann die Oberfläche der Kaminstruktur 418 dazu genutzt werden, um Wärme abzuleiten.

Im Übrigen gilt das Gleiche wie den vorhergehenden Ausführungsbeispielen.

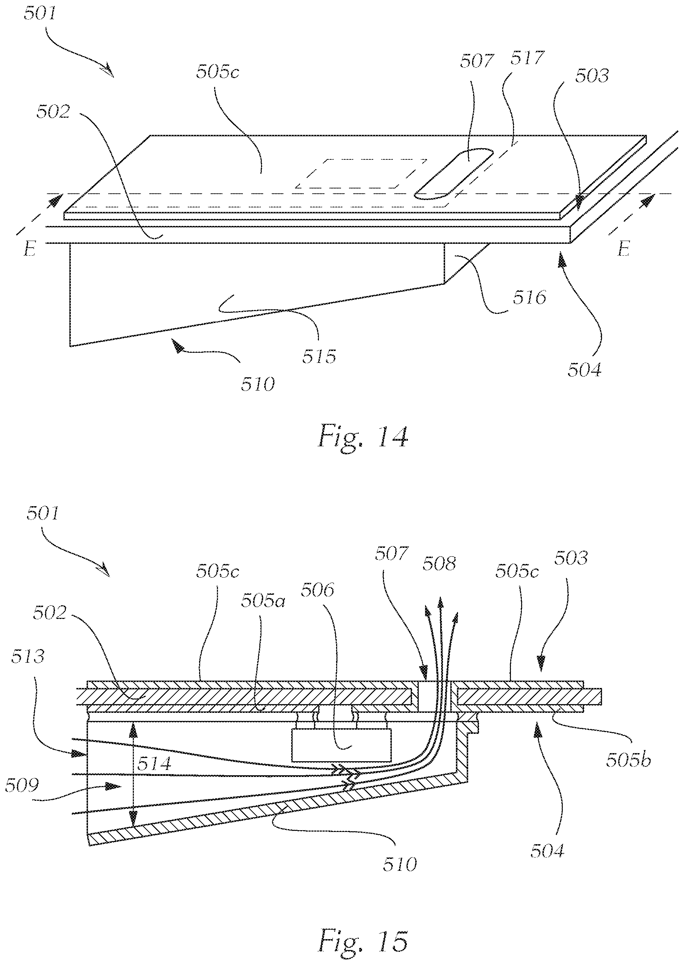

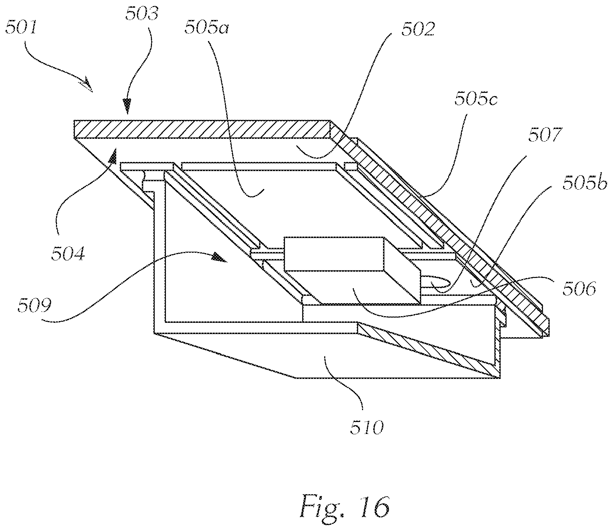

In **Fig. 14** bis **Fig. 16** ist eine fünfte Ausführungsform einer Bauteilkühlvorrichtung 501 dargestellt. Ein Bauteil 506 ist auf einer Unterseite 504 einer Leiterplatte 502 gelegen, das heißt das Bauteil 506 ist innerhalb eines Strömungskanals 509 angeordnet. Somit kann die im Strömungskanal 509 fließende Strömung die Abwärme des Bauteils 506 direkt abführen und die Effizienz der Bauteilkühlvorrichtung 501 kann weiter erhöht werden. Diese Variante der erfindungsgemäßen Bauteilkühlvorrichtung 501 ist allerdings nur dann möglich, wenn das Bauteil 506 keine Zusatzfunktion, wie beispielsweise die Lichtemission von der Leiterplatte 502 nach oben bei einer Leuchtdiode, zu erfüllen hat. Die gezeigte Variante der Bauteilkühlvorrichtung kann bei Verwendung von beispielsweise passiven Bauteilen als Bauteil 506, wie beispielsweise ohmsche Widerstände geeignet sein.

Im Übrigen gilt das Gleiche wie den vorhergehenden Ausführungsbeispielen.

Grundsätzlich sind die hier genannten Ausführungsbeispiele untereinander kombinierbar, das heißt beispielsweise, dass eine Kaminstruktur je nach Erfordernis oder verfügbarem Einbauraum in einem Fahrzeugscheinwerfer eingesetzt werden kann. Ebenso kann beispielsweise die Lage, die Anzahl und/ oder die Formgebung der gewählten Leiterplattendurchführungen 107, 207, 307a, 307b, 407, 507 für die jeweilige Anwendung angepasst werden.

Das Gleiche trifft für die Führung 10, 110, 210, 310, 410, 510 zu, die beispielsweise eine gewölbte Formgebung aufweisen kann oder in den Abmessungen variieren kann. Die Führung 10, 110, 210, 310, 410, 510 selbst kann auf unterschiedliche Weisen mit der Leiterplatte 102, 202, 302, 402, 502 verbunden sein, wie beispielsweise durch Klebung, vorzugsweise durch einen elektrisch schlecht oder nicht leitenden, aber thermisch gut leitenden Klebstoff oder durch Steck oder Schraubverbindungen.

Alternativ kann der erfindungsgemäße Strömungskanal gebogen ausgeführt sein, um etwaige Einbauvorschriften erfüllen zu können. Der Strömungskanal kann einstückig ausgeführt sein; das heißt, hierbei muss die Leiterplatte nicht zwangsläufig einen Bestandteil des Strömungskanals in Form einer Seitenwand bilden. Die Lage des Auslasses im Strömungskanal ist keineswegs auf die in den Ausführungsbeispielen gezeigten Positionen beschränkt, sondern kann aufgrund der jeweiligen Einbausituation entsprechen angepasst werden und beispielsweise auch in der Stirnseite gelegen sein. Es ist auch denkbar, dass für mehrere Bauteile ein oder mehrere Strömungskanäle angeordnet sind, die zudem gegebenenfalls wichtige Komponenten miteinander teilen, wie Seitenwände von Strömungskanälen oder gemeinsam genutzte Leiterplattendurchführungen.

Der Auslass des Strömungskanals kann mit den hohlen Leiterplattendurchführungen alternativ durch zusätzliche Verbindungselemente, wie beispielsweise eine oder mehrere Leitungen oder Rohren verbunden sein. Dies kann erforderlich sein, wenn beispielsweise der verfügbare Bauraum begrenzt ist und die Wärme verstärkt über den Strömungskanal abgeführt werden soll.

Zumindest alle hier genannten Ausführungsbeispiele sowie die Weiterbildungen der Erfindung gemäß der eingangs ausgeführten Beschreibung sind folglich kombinierbar und werden vom Schutzbereich der folgenden Ansprüche abgedeckt.

### Bezugszeichenliste:

- 101, 201, 301, 401, 501: Bauteilkühlvorrichtung
- 102,202,302,402,502: Leiterplatte
- 103,203,303,403,503: Oberseite
- 104,204,304,404,504: Unterseite
- 105a, 205a, 305a, 405a, 505a: erste Kontaktanschlussfläche
- 105b, 205b, 305b, 405b, 505b: zweite Kontaktanschlussfläche
- 105c, 205c, 305c, 305d, 405c, 505c: Wärmeabstrahlfläche
- 6, 106, 206, 306, 406, 506: Bauteil
- 6a, 6b, 106a, 106b: Kontaktanschlüsse des Bauteils
- 106c, 106d, 406c, 406d: Lötverbindung des Bauteils
- 107, 207, 307a, 307b, 407, 507: hohle Leiterplattendurchführung
- 101, 208, 408, 508: Konvektionsfluss
- 109, 209, 309, 409, 509: Strömungskanal
- 10, 110, 210, 310,410, 510: Führung
- 110a, 210a, 310a, 410a, 510a: Lötverbindung der Führung
- 311: Kühlfläche
- 311a: Bauteilkontur
- 312a, 312b: thermischer Fluss
- 13, 113, 213, 313, 413, 513: Einlass
- 114: Höhe des Strömungskanals
- 15, 115, 215, 315, 415, 515: Seitenwände des Strömungskanals
- 16, 116, 216, 316, 416, 516: Stirnseite des Strömungskanals
- 117, 217, 317: Begrenzungsfläche
- 418: Kaminstruktur
- 418a: Lötverbindung der Kaminstruktur
- 419: Kaminhöhe
- 420: Kamindurchmesser

## Patentansprüche

1. Bauteilkühlvorrichtung (101, 201, 301, 401, 501), umfassend eine Leiterplatte (102, 202, 302, 402, 502), wobei die Leiterplatte (102, 202, 302, 402, 502) eine Oberseite (103, 203, 303, 403, 503) und eine der Oberseite (103, 203, 303, 403, 503) abgewandte Unterseite (104, 204, 304, 404, 504), sowie zumindest ein elektronisches Bauteil (6,106, 206, 306, 406, 506) und zumindest eine hohle Leiterplattendurchführung (107, 207, 307a, 307b, 407, 507) für ein gasförmiges Kühlmedium zum Kühlen des Bauteils aufweist,
**dadurch gekennzeichnet, dass**
an der Unterseite (104, 204, 304, 404, 504) der Leiterplatte (102, 202, 302, 402, 502) eine Führung (10,110, 210, 310, 410, 510) angeordnet ist, welche einen Strömungskanal (109, 209, 309, 409, 509) bildet, der zumindest einen Einlass (13,113, 213, 313, 413, 513) und zumindest einen, von der zumindest einen Leiterplattendurchführung (107, 207, 307a, 307b, 407, 507) gebildeten Auslass für zumindest einen Konvektionsfluss (108, 208, 408, 508) des Kühlmediums aufweist,
wobei der Strömungskanal (109, 209, 309, 409, 509) durch die Führung (10, 110, 210, 310, 410, 510) und einen Bereich der Unterseite (104, 204, 304, 404, 504) der Leiterplatte (102, 202, 302, 402, 502) begrenzt ist.

2. Bauteilkühlvorrichtung (101, 201, 301, 401, 501) nach Anspruch 1, **dadurch gekennzeichnet, dass** die zumindest eine Leiterplattendurchführung (107, 207, 307a, 307b, 407, 507) ebenfalls in diesem Bereich der Unterseite gelegen ist.

3. Bauteilkühlvorrichtung (101, 201, 301, 401, 501) nach einem der Ansprüche 1 oder 2, **dadurch gekennzeichnet, dass** ein Bereich des Strömungskanals (109, 209, 309, 409, 509) auf der Unterseite (104, 204, 304, 404, 504) der Leiterplatte (102, 202, 302, 402, 502) zumindest eine Kühlfläche (111, 311) umfasst, wobei die zumindest eine Kühlfläche (111, 311) im Wesentlichen durch eine Kontur (311a) des zumindest einen Bauteils (6, 106, 206, 306, 406, 506) auf der Leiterplatte (102, 202, 302, 402, 502) begrenzt ist und auf der Unterseite (104, 204, 304, 404, 504) der Leiterplatte (102, 202, 302, 402, 502) gelegen ist.

4. Bauteilkühlvorrichtung (101, 201, 301, 401, 501) nach einem der Ansprüche 1 bis 3, **dadurch gekennzeichnet, dass** der zumindest eine Einlass (13, 113, 213, 313, 413, 513) des Strömungskanals (109, 209, 309, 409, 509) eine vorzugsweise rechteckige Form aufweist und der Querschnitt des zumindest einen Einlasses (13, 113, 213, 313, 413, 513) größer ist als der Querschnitt des zumindest einen Auslasses, sowie der Strömungskanal (109, 209, 309, 409, 509) eine Höhe (114) quer zur Leiterplatte (102, 202, 302, 402, 502) aufweist, die vom zumindest einen Einlass (13, 113, 213, 313, 413, 513) zum zumindest einen Auslass hin abnimmt.

5. Bauteilkühlvorrichtung (101, 201, 301, 401, 501) nach einem der Ansprüche 1 bis 4, **dadurch gekennzeichnet, dass** die Führung (10, 110, 210, 310, 410, 510) aus drei aneinander angrenzenden Seitenwänden (15, 115, 215, 315, 415, 515) und einer angrenzenden Stirnseite (16, 116, 216, 316, 416, 516) gebildet ist und die Führung (10, 110, 210, 310, 410, 510) gemeinsam mit dem Bereich der Unterseite (104, 204, 304, 404, 504) der Leiterplatte (102, 202, 302, 402, 502) und der zumindest einen Leiterplattendurchführung (107, 207, 307a, 307b, 407, 507) den Strömungskanal (109, 209, 309, 409, 509) bildet.

6. Bauteilkühlvorrichtung (101, 201, 301, 401, 501) nach einem der Ansprüche 1 bis 5, **dadurch gekennzeichnet, dass** zumindest eine Kontaktanschlussfläche (105a, 205a, 305a, 405a, 505a, 105b, 205b, 305b, 405b, 505b) auf der Oberseite (103, 203, 303, 403, 503) mit zumindest einer Wärmeabstrahlfläche (105c, 205c, 305c, 305d, 405c, 505c) auf der Unterseite (104, 204, 304, 404, 504) durch zumindest eine hohle, elektrisch leitende Leiterplattendurchführung (107, 207, 307a, 307b, 407, 507) verbunden ist.

7. Bauteilkühlvorrichtung (101, 201, 301, 401, 501) nach einem der Ansprüche 1 bis 6, **dadurch gekennzeichnet, dass** die Leiterplatte (102, 202, 302, 402, 502) einlagig ist und beidseitig vorzugsweise strukturierte Metallschichten aufweist.

8. Bauteilkühlvorrichtung (101, 201, 301, 401, 501) nach einem der Ansprüche 1 bis 7, **dadurch gekennzeichnet, dass** zumindest eine Kaminstruktur (418) zum Verstärken des zumindest einen Konvektionsflusses (108, 208, 408) auf der Oberseite (103, 203, 303, 403, 503) angeordnet ist und die zumindest eine hohle Leiterplattendurchführung (107, 207, 307a, 307b, 407, 507) in die zumindest eine thermische Kaminstruktur (418) mündet.

9. Bauteilkühlvorrichtung (101, 201, 301, 401, 501) nach Anspruch 8, **dadurch gekennzeichnet, dass** die zumindest eine Kaminstruktur (418) eine Kaminhöhe (419) aufweist, die größer ist als der Durchmesser der Leiterplattendurchführung (107, 207, 307a, 307b, 407, 507), bevorzugt zumindest fünfmal größer, besonders bevorzugt zumindest zehnmal größer, wobei der Kamindurchmesser (420) im Wesentlichen dem Durchmesser der zumindest einen Leiterplattendurchführung (107, 207, 307a, 307b, 407, 507) entspricht.

10. Bauteilkühlvorrichtung (101, 201, 301, 401, 501) nach Anspruch 8 oder 9, **dadurch gekennzeichnet, dass** der Kamindurchmesser (420) zumindest teilweise entlang der Kaminhöhe (419) nicht konstant oder an einem Ende der Kaminstruktur (418), an dem eine Lötverbindung (418a) angebracht ist, erweitert verläuft.

11. Bauteilkühlvorrichtung (101, 201, 301, 401, 501) nach einem der Ansprüche 8 bis 10, **dadurch gekennzeichnet, dass** mehrere Kaminstrukturen (418) stromauf oder stromab der zumindest einen Leiterplattendurchführung (107, 207, 307a, 307b, 407, 507) aneinandergereiht sind und vorzugsweise aus unterschiedlichen Materialien, die insbesondere mechanisch fest oder elastisch formbar ausgebildet sind, beispielsweise ein Schlauch, insbesondere ein Gummi- oder Kunststoffschlauch, bestehen und gemeinsam eine Kaminstruktur ausbilden.

12. Bauteilkühlvorrichtung (101, 201, 301, 401, 501) nach Anspruch 11, **dadurch gekennzeichnet, dass** die gemeinsame Kaminstruktur mit zumindest einer weiteren Komponente eines Fahrzeugscheinwerfers verbunden ist.

13. Bauteilkühlvorrichtung (101, 201, 301, 401, 501) nach einem der Ansprüche 1 bis 12, **dadurch gekennzeichnet, dass** die Leiterplatte (102, 202, 302, 402, 502) in einer Einbaulage vorzugsweise in einem Fahrzeugscheinwerfer im Wesentlichen horizontal orientiert ist, insbesondere in einem Winkel der Leiterplatte (102, 202, 302, 402, 502) zur Horizontalen im Bereich -45° bis +45°, besonders bevorzugt im Bereich -10° bis +10°, äußerst bevorzugt im Bereich -5° bis +5°.

14. Bauteilkühlvorrichtung (101, 201, 301, 401, 501) nach einem der Ansprüche 1 bis 13, **dadurch gekennzeichnet, dass** die Bauteilkühlvorrichtung (101, 201, 301, 401, 501) innerhalb eines Fahrzeugscheinwerfers angeordnet ist und dazu eingerichtet ist, eine Lichtquelle vorzugsweise für eine Fernlicht-Lichtquelle oder eine Abblendlicht-Lichtquelle zu kühlen.

15. Fahrzeugscheinwerfer mit einer oder mehreren Lichtquellen, welche Licht zur Erzeugung einer Lichtverteilung, insbesondere einer Fernlicht- oder Abblendlichtlichtverteilung, abstrahlen können, mit einer Bauteilkühlvorrichtung nach einem der Ansprüche 1 bis 14 zur Kühlung der einen oder mehreren Lichtquellen.

## Claims

1. A component cooling device (101, 201, 301, 401, 501) comprising: a circuit board (102, 202, 302, 402, 502), the circuit board (102, 202, 302, 402, 502) having an upper side (103, 203, 303, 403, 503) and a lower side (104, 204, 304, 404, 504) facing away from the upper side (103, 203, 303, 403, 503); and at least one electronic component (6, 106, 206, 306, 406, 506) and at least one hollow circuit board opening (107, 207, 307a, 307b, 407, 507) for a gaseous cooling medium for cooling the component,
**characterised in that**
on the lower side (104, 204, 304, 404, 504) of the circuit board (102, 202, 302, 402, 502) is provided a guide (10, 110, 210, 310, 410, 510) which forms a flow channel (109, 209, 309, 409, 509) that has at least one inlet (13, 113, 213, 313, 413, 513) and at least one outlet which is formed by the at least one circuit board opening (107, 207, 307a, 307b, 407, 507), for at least one convection flow (108, 208, 408, 508) of the cooling medium,
wherein the flow channel (109, 209, 309, 409, 509) is delimited by the guide (10, 110, 210, 310, 410, 510) and a region of the lower side (104, 204, 304, 404, 504) of the circuit board (102, 202, 302, 402, 502).

2. The component cooling device (101, 201, 301, 401, 501) according to claim 1, **characterised in that** the at least one circuit board opening (107, 207, 307a, 307b, 407, 507) is likewise arranged in this region of the lower side.

3. The component cooling device (101, 201, 301, 401, 501) according to either one of claims 1 or 2, **characterised in that** a region of the flow channel (109, 209, 309, 409, 509) on the lower side (104, 204, 304, 404, 504) of the circuit board (102, 202, 302, 402, 502) comprises at least one cooling area (111, 311), wherein the at least one cooling area (111, 311) is delimited substantially by a contour (311a) of the at least one component (6, 106, 206, 306, 406, 506) on the circuit board (102, 202, 302, 402, 502) and is arranged on the lower side (104, 204, 304, 404, 504) of the circuit board (102, 202, 302, 402, 502).

4. The component cooling device (101, 201, 301, 401, 501) according to any one of claims 1 to 3, **characterised in that** the at least one inlet (13, 113, 213, 313, 413, 513) of the flow channel (109, 209, 309, 409, 509) has a preferably rectangular shape and the cross-section of the at least one inlet (13, 113, 213, 313, 413, 513) is larger than the cross-section of the at least one outlet, and the flow channel (109, 209, 309, 409, 509) has a height (114) transversely to the circuit board (102, 202, 302, 402, 502) that decreases from the at least one inlet (13, 113, 213, 313, 413, 513) to the at least one outlet.

5. The component cooling device (101, 201, 301, 401, 501) according to any one of claims 1 to 4, **characterised in that** the guide (10, 110, 210, 310, 410, 510) is formed from three adjoining side walls (15, 115, 215, 315, 415, 515) and an adjoining end face (16, 116, 216, 316, 416, 516) and the guide (10, 110, 210, 310, 410, 510), jointly with the region of the lower side (104, 204, 304, 404, 504) of the circuit board (102, 202, 302, 402, 502) and the at least one circuit board opening (107, 207, 307a, 307b, 407, 507), forms the flow channel (109, 209, 309, 409, 509).

6. The component cooling device (101, 201, 301, 401, 501) according to any one of claims 1 to 5, **characterised in that** at least one contact connection area (105a, 205a, 305a, 405a, 505a, 105b, 205b, 305b, 405b, 505b) on the upper side (103, 203, 303, 403, 503) is connected to at least one heat radiation area (105c, 205c, 305c, 305d, 405c, 505c) on the lower side (104, 204, 304, 404, 504) by at least one hollow, electrically conductive circuit board opening (107, 207, 307a, 307b, 407, 507).

7. The component cooling device (101, 201, 301, 401, 501) according to any one of claims 1 to 6, **characterised in that** the circuit board (102, 202, 302, 402, 502) is formed in one layer and has metal layers, which preferably are structured, on both sides.

8. The component cooling device (101, 201, 301, 401, 501) according to any one of claims 1 to 7, **characterised in that** at least one chimney structure (418) for intensifying the at least one convection flow (108, 208, 408) is arranged on the upper side (103, 203, 303, 403, 503) and the at least one hollow circuit board opening (107, 207, 307a, 307b, 407, 507) leads out into the at least one thermal chimney structure (418).

9. The component cooling device (101, 201, 301, 401, 501) according to claim 8, **characterised in that** the at least one chimney structure (418) has a chimney height (419) that is greater than the diameter of the circuit board opening (107, 207, 307a, 307b, 407, 507), preferably at least five times greater, particularly preferably at least ten times greater, wherein the chimney diameter (420) corresponds substantially to the diameter of the at least one circuit board opening (107, 207, 307a, 307b, 407, 507).

10. The component cooling device (101, 201, 301, 401, 501) according to claim 8 or 9, **characterised in that** the chimney diameter (420) at least in part extends in a non-constant manner along the chimney height (419) or, at one end of the chimney structure (418) at which a solder connection (418a) is provided, extends in a widening manner.

11. The component cooling device (101, 201, 301, 401, 501) according to any one of claims 8 to 10, **characterised in that** a plurality of chimney structures (418) are arranged in a row upstream or downstream of the at least one circuit board opening (107, 207, 307a, 307b, 407, 507) and preferably are made of different materials, which in particular are designed to be mechanically rigid or elastically malleable, for example a tube, in particular a rubber or plastics tube, and jointly form a chimney structure.

12. The component cooling device (101, 201, 301, 401, 501) according to claim 11, **characterised in that** the combined chimney structure is connected to at least one further component of a vehicle headlamp.

13. The component cooling device (101, 201, 301, 401, 501) according to any one of claims 1 to 12, **characterised in that** the circuit board (102, 202, 302, 402, 502) in an installed position preferably in a vehicle headlamp is oriented substantially horizontally, in particular with an angle of the circuit board (102, 202, 302, 402, 502) to the horizontal in the range of -45° to +45°, more preferably in the range of -10° to +10°, most preferably in the range of -5° to +5°.

14. The component cooling device (101, 201, 301, 401, 501) according to any one of claims 1 to 13, **characterised in that** the component cooling device (101, 201, 301, 401, 501) is arranged within a vehicle headlamp and is designed to cool a light source preferably for a main beam light source or a dipped beam light source.

15. A vehicle headlamp including one or more light sources configured to radiate light in order to produce a light distribution, in particular a main beam or dipped beam light distribution, comprising a component cooling device according to any one of claims 1 to 14 for cooling the one or more light sources.

## Revendications

1. Dispositif de refroidissement de composant (101, 201, 301, 401, 501), comportant une carte de circuit imprimé (102, 202, 302, 402, 502), la carte de circuit imprimé (102, 202, 302, 402, 502) présentant une face supérieure (103, 203, 303, 403, 503) et une face inférieure (104, 204, 304, 404, 504) tournée à l'opposé de la face supérieure (103, 203, 303, 403, 503), ainsi qu'au moins un composant électronique (6, 106, 206, 306, 406, 506) et au moins un passage traversant (107, 207, 307a, 307b, 407, 507), creux, formé dans la carte de circuit imprimé, pour un fluide de refroidissement gazeux servant à refroidir le composant,
**caractérisé par le fait que**
sur la face inférieure (104, 204, 304, 404, 504) de la carte de circuit imprimé (102, 202, 302, 402, 502), est disposé un guide (10, 110, 210, 310, 410, 510), lequel forme un canal d'écoulement (109, 209, 309, 409, 509) qui présente au moins une admission (13, 113, 213, 313, 413, 513) et au moins une évacuation formée par ledit au moins un passage traversant (107, 207, 307a, 307b, 407, 507) de la carte de circuit imprimé, pour au moins un flux de convection (108, 208, 408, 508) du fluide de refroidissement,
le canal d'écoulement (109, 209, 309, 409, 509) étant délimité par le guide (10, 110, 210, 310, 410, 510) et une région de la face inférieure (104, 204, 304, 404, 504) de la carte de circuit imprimé (102, 202, 302, 402, 502).

2. Dispositif de refroidissement de composant (101, 201, 301, 401, 501) selon la revendication 1, **caractérisé par le fait que** ledit au moins un passage traversant (107, 207, 307a, 307b, 407, 507) de la carte de circuit imprimé est situé également dans cette région de la face inférieure.

3. Dispositif de refroidissement de composant (101, 201, 301, 401, 501) selon l'une des revendications 1 ou 2, **caractérisé par le fait qu'**une région du canal d'écoulement (109, 209, 309, 409, 509) sur la face inférieure (104, 204, 304, 404, 504) de la carte de circuit imprimé (102, 202, 302, 402, 502) comporte au moins une surface de refroidissement (111, 311), ladite au moins une surface de refroidissement (111, 311) étant délimitée sensiblement par un contour (311a) dudit au moins un composant (6, 106, 206, 306, 406, 506) sur la carte de circuit imprimé (102, 202, 302, 402, 502) et étant située sur la face inférieure (104, 204, 304, 404, 504) de la carte de circuit imprimé (102, 202, 302, 402, 502).

4. Dispositif de refroidissement de composant (101, 201, 301, 401, 501) selon l'une des revendications 1 à 3, **caractérisé par le fait que** ladite au moins une admission (13, 113, 213, 313, 413, 513) du canal d'écoulement (109, 209, 309, 409, 509) présente une forme de préférence rectangulaire et la section transversale de ladite au moins une admission (13, 113, 213, 313, 413, 513) est plus grande que la section transversale de ladite au moins une évacuation, et le canal d'écoulement (109, 209, 309, 409, 509) présente une hauteur (114) transversalement à la carte de circuit imprimé (102, 202, 302, 402, 502) qui diminue de ladite au moins une admission (13, 113, 213, 313, 413, 513) à ladite au moins une évacuation.

5. Dispositif de refroidissement de composant (101, 201, 301, 401, 501) selon l'une des revendications 1 à 4, **caractérisé par le fait que** le guide (10, 110, 210, 310, 410, 510) est formé de trois parois latérales adjacentes (15, 115, 215, 315, 415, 515) et d'une face frontale adjacente (16, 116, 216, 316, 416, 516) et le guide (10, 110, 210, 310, 410, 510), conjointement avec la région de la face inférieure (104, 204, 304, 404, 504) de la carte de circuit imprimé (102, 202, 302, 402, 502) et dudit au moins un passage traversant (107, 207, 307a, 307b, 407, 507) de la carte de circuit imprimé, forme le canal d'écoulement (109, 209, 309, 409, 509).

6. Dispositif de refroidissement de composant (101, 201, 301, 401, 501) selon l'une des revendications 1 à 5, **caractérisé par le fait qu'**au moins une surface de connexion de contact (105a, 205a, 305a, 405a, 505a, 105b, 205b, 305b, 405b, 505b) sur la face supérieure (103, 203, 303, 403, 503) est reliée à au moins une surface de rayonnement thermique (105c, 205c, 305c, 305d, 405c, 505c) sur la face inférieure (104, 204, 304, 404, 504) par au moins un passage traversant (107, 207, 307a, 307b, 407, 507) conducteur de l'électricité, creux, de la carte de circuit imprimé.

7. Dispositif de refroidissement de composant (101, 201, 301, 401, 501) selon l'une des revendications 1 à 6, **caractérisé par le fait que** la carte de circuit imprimé (102, 202, 302, 402, 502) est monocouche et présente sur les deux côtés des couches métalliques de préférence structurées.

8. Dispositif de refroidissement de composant (101, 201, 301, 401, 501) selon l'une des revendications 1 à 7, **caractérisé par le fait qu'**au moins une structure de cheminée (418) pour l'intensification dudit au moins un flux de convection (108, 208, 408) est disposée sur la face supérieure (103, 203, 303, 403, 503) et ledit au moins un passage traversant (107, 207, 307a, 307b, 407, 507), creux, de la carte de circuit imprimé, débouche dans ladite au moins une structure de cheminée thermique (418).

9. Dispositif de refroidissement de composant (101, 201, 301, 401, 501) selon la revendication 8, **caractérisé par le fait que** ladite au moins une structure de cheminée (418) présente une hauteur de cheminée (419) qui est plus grande que le diamètre du passage traversant (107, 207, 307a, 307b, 407, 507) de la carte de circuit imprimé, de préférence au moins cinq fois plus grande, de manière particulièrement préférée au moins dix fois plus grande, le diamètre de cheminée (420) correspondant sensiblement au diamètre dudit au moins un passage traversant (107, 207, 307a, 307b, 407, 507) de la carte de circuit imprimé.

10. Dispositif de refroidissement de composant (101, 201, 301, 401, 501) selon l'une des revendications 8 ou 9, **caractérisé par le fait que** le diamètre de cheminée (420) au moins en partie s'étend d'une manière non constante le long de la hauteur de cheminée (419) ou, à une extrémité de la structure de cheminée (418), à laquelle une liaison de brasage (418a) est disposée, s'étend d'une manière s'élargissant.

11. Dispositif de refroidissement de composant (101, 201, 301, 401, 501) selon l'une des revendications 8 à 10, **caractérisé par le fait que** plusieurs structures de cheminée (418) sont disposées en une rangée en amont ou en aval dudit au moins un passage traversant (107, 207, 307a, 307b, 407, 507) de la carte de circuit imprimé et, de préférence, sont constituées de différents matériaux, qui sont formés en particulier mécaniquement rigides ou malléables élastiquement, par exemple un tuyau, en particulier un tuyau en caoutchouc ou en matière plastique, et forment conjointement une structure de cheminée.

12. Dispositif de refroidissement de composant (101, 201, 301, 401, 501) selon la revendication 11, **caractérisé par le fait que** la structure de cheminée combinée est reliée à au moins un autre composant d'un phare de véhicule.

13. Dispositif de refroidissement de composant (101, 201, 301, 401, 501) selon l'une des revendications 1 à 12, **caractérisé par le fait que** la carte de circuit imprimé (102, 202, 302, 402, 502) dans une position de montage de préférence dans un phare de véhicule est orientée sensiblement horizontalement, en particulier selon un angle de la carte de circuit imprimé (102, 202, 302, 402, 502) par rapport à l'horizontale dans la plage de -45° à +45°, de façon particulièrement préférée dans la plage de -10° à +10°, de la façon que l'on préfère le plus dans la plage de -5° à +5°.

14. Dispositif de refroidissement de composant (101, 201, 301, 401, 501) selon l'une des revendications 1 à 13, **caractérisé par le fait que** le dispositif de refroidissement de composant (101, 201, 301, 401, 501) est disposé à l'intérieur d'un phare de véhicule et est conçu de façon à refroidir une source de lumière de préférence pour une source de lumière de feu de route ou une source de lumière de feu de croisement.

15. Phare de véhicule comportant une ou plusieurs sources de lumière, lesquelles peuvent irradier de la lumière pour réaliser une distribution de lumière, en particulier une distribution de lumière de feu de route ou de feu de croisement, comportant un dispositif de refroidissement de composant selon l'une des revendications 1 à 14 pour le refroidissement de la ou des sources de lumière.
